# EUROPÄISCHE PATENTSCHRIFT

(11) **EP 1 787 108 B1**
(45) Veröffentlichungstag und Bekanntmachung des Hinweises auf die Patenterteilung: **08.07.2009**
(21) Anmeldenummer: 05773907.0
(22) Anmeldetag: 24.08.2005
(51) Int. Cl.: G01N 21/75, G01N 21/78

(54) **VORRICHTUNG ZUM AUSWERTEN BIOCHEMISCHER PROBEN**
DEVICE FOR ANALYSIS OF BIOCHEMICAL SAMPLES
DISPOSITIF D'ANALYSE D'ECHANTILLONS BIOCHIMIQUES

(30) Priorität: 08.09.2004 AT 15022004
(43) Veröffentlichungstag der Anmeldung: 23.05.2007
(73) Patentinhaber: Nanoident Technologies AG, 4020 Linz (AT)
(72) Erfinder: PADINGER, Franz, A-4502 St. Marien (AT); SCHRÖTER, Klaus, G., 10707 Berlin (DE)
(74) Vertreter: Hübscher, Helmut
(86) Internationale Anmeldenummer: PCT/AT2005/000338
(87) Internationale Veröffentlichungsnummer: WO 2006/026796

(56) Entgegenhaltungen:
- WO-A-99/39395
- US-A- 5 504 323
- US-A- 5 629 533
- PATENT ABSTRACTS OF JAPAN Bd. 014, Nr. 308 (E-0947), 3. Juli 1990 (1990-07-03) & JP 02 098177 A (RICOH CO LTD), 10. April 1990 (1990-04-10)
- YU G ET AL: "SEMICONDUCTING POLYMER DIODES: LARGE SIZE, LOW COST PHOTODETECTORS WITH EXCELLENT VISIBLE-ULTRAVIOLET SENSITIVITY" APPLIED PHYSICS LETTERS, AIP, AMERICAN INSTITUTE OF PHYSICS, MELVILLE, NY, US, Bd. 64, Nr. 25, 20. Juni 1994 (1994-06-20), Seiten 3422-3424, XP000454599 ISSN: 0003-6951

## Beschreibung

Die Erfindung bezieht sich auf eine Vorrichtung zum Auswerten biochemischer Proben mit einem Probenträger, mit einer Bilderfassungseinrichtung, die eine an eine Auswerteschaltung angeschlossene lichtempfindliche Lage aufweist, und mit einer Beleuchtungseinrichtung für die Proben.

Der Umstand, daß bei bestimmten Reaktionen zwischen einer Biomolekülschicht und einem Reagenz eine als Farbumschlag erkennbare spektrale Änderung der Lichtabsorption innerhalb der Biomolekülschicht auftritt oder entsprechend markierte Biomoleküle durch eine Anregung mit Licht beispielsweise eine Fluoreszenzstrahlung abgeben, kann dazu genützt werden, solche Proben hinsichtlich einer spektralen Änderung des Absorptionsverhaltens oder der Abgabe einer Fluoreszenzstrahlung mit Hilfe einer Bilderfassungseinrichtung zu untersuchen. Zu diesem Zweck ist es bekannt (DE 101 46 902 A1), die Bilderfassungseinrichtung mit einer Lage lichtempfindlicher Elemente in einer Matrixanordnung zu versehen, die der Anordnung der Proben auf dem Träger entspricht, so daß das von den beleuchteten Proben über ein optisches Linsensystem von den einzelnen lichtempfindlichen Elementen empfangene Licht den einzelnen Proben zugeordnet und ausgewertet werden kann. Als lichtempfindliche Elemente kommen Photodioden oder Phototransistoren in Dünnschichttechnik zur Anwendung, die einzeln in eine Auswerteschaltung ausgelesen werden können. Nachteilig bei dieser bekannten Vorrichtung zum Auswerten biochemischer Proben ist vor allem der mit der Bilderfassungseinrichtung verbundene Aufwand, der sich nicht nur auf den konstruktiven Aufbau der Bilderfassungseinrichtung, sondern auch auf das optische Linsensystem zwischen dem Probenträger und der Bilderfassungseinrichtung sowie die genaue Ausrichtung des Probenträgers gegenüber dem Linsensystem bzw. der Bilderfassungseinrichtung bezieht.

Aus der WO 99/39395 A1 sind Photodioden bekannt, die eine photoaktive Schicht auf der Basis organischer Halbleiter zwischen zwei Elektrodenschichten aufweisen, von denen eine Elektrodenschicht lichtdurchlässig ausgebildet ist, und durch unterschiedliche Vorspannungen entweder als lichtempfindliche Elemente oder als lichtemittierende Elemente genützt werden können. Diese in Zeilen und Spalten eines Photodetektors angeordneten, schaltbaren Photodioden eignen sich jedoch nicht zum Auswerten biochemischer Proben, weil die hierfür erforderliche Probenbeleuchtung nicht zugleich mit der Auswertung des von den Proben empfangenen Lichtes durchgeführt werden kann. Hierfür sind ja die Photodioden umzuschalten. Abgesehen davon ist die Lichtempfindlichkeit von Photodioden auf Basis organischer Halbleiter unbefriedigend, wenn diese Photodioden auch zur Lichtemission dienen sollen.

Schließlich ist ein optischer Sensor mit organischen Halbleiterelementen zur Lichtemission und mit organischen Halbleitern zur Auswertung des emittierten Lichtes bekannt (US 5 629 533 A). Die lichtemittierenden Dioden sind mit Indikatoren versetzt, die mit einem Analyt reagieren und dabei das emittierte Licht verändern, so daß die Anwesenheit eines Analyts überwacht werden kann. Mit Hilfe eines solchen optischen Sensors lassen sich jedoch nur Proben untersuchen, die mit den lichtemittierenden Elementen chemisch reagieren.

Der Erfindung liegt somit die Aufgabe zugrunde, eine Vorrichtung zum Auswerten biochemischer Proben der eingangs geschilderten Art so auszugestalten, daß mit einfachen konstruktiven Mitteln eine sichere Probenauswertung gewährleistet werden kann.

Die Erfindung löst die gestellte Aufgabe dadurch, daß die auf dem Probenträger vorgesehene lichtempfindliche Lage der Bilderfassungseinrichtung eine photoaktive Schicht auf der Basis organischer Halbleiter zwischen zwei Elektrodenschichten umfaßt, von denen die Elektrodenschicht zwischen der photoaktiven Schicht und den Proben zumindest bereichsweise lichtdurchlässig ausgebildet ist, daß die beiden Elektrodenschichten für die photoaktive Schicht aus einander kreuzenden Leiterbahnen aufgebaut sind, die im Kreuzungsbereich lichtempfindliche Elemente in der photoaktiven Schicht begrenzen, daß die photoaktive Schicht neben den lichtempfindlichen Elementen lichtemittierende Elemente in ausgewählten Kreuzungsbereichen der Leiterbahnen der beiden Elektrodenschichten bildet und daß die photoaktive Schicht im Bereich der lichtemittierenden Elemente einen gegenüber den Bereichen der lichtempfindlichen Elemente unterschiedlichen Aufbau aufweist.

Aufgrund des Einsatzes einer photoaktiven Schicht auf der Basis organischer Halbleiter ergeben sich vergleichsweise einfache Konstruktionsbedingungen, die auf der Löslichkeit der organischen Halbleiterwerkstoffe in herkömmlichen Lösungsmitteln beruhen. Dies bedeutet, daß eine Bilderfassungseinrichtung auf der Basis organischer Halbleiter mit einem im Vergleich zu Photodioden oder Phototransistoren auf der Basis anorganischer Halbleiter geringen Aufwand auf den Träger für die biochemischen Proben aufgebracht werden kann, was eine unmittelbare Zuordnung der lichtempfindlichen Lage zu den Proben mit dem Vorteil ermöglicht, daß ein optisches Linsensystem entfallen kann. Dies gilt nicht nur für die Erfassung von Einzelproben, sondern auch für die Auswertung einer Vielzahl von auf einem Träger aufgebrachten Proben, denen lichtempfindliche Elemente in einer der Probenordnung entsprechenden Matrixordnung zugeteilt werden müssen. Wegen der im Vergleich zu anorganischen Halbleitern geringen Beweglichkeit der Ladungsträger photoaktiver Schichten auf der Basis von organischen Halbleitern bedarf es nämlich keiner besonderen Maßnahmen, um einzelne lichtempfindliche Bereiche voneinander abzugrenzen. Zu diesem Zweck brauchen die beiden Elektrodenschichten für die photoaktive Schicht lediglich aus einander kreuzenden Leiterbahnen aufgebaut zu werden, die im Kreuzungsbereich lichtempfindliche Elemente in der photoaktiven Schicht begrenzen, weil zufolge der vergleichsweise geringen Ladungsbeweglichkeit der Ladungstransport im wesentlichen auf den Kreuzungsbereich der Leiterbahnen beschränkt ist und der Einfluß einer Ladungsbewegung zwischen benachbarten Kreuzungsbereichen der Leiterbahnen innerhalb der photoaktiven Schicht im allgemeinen vernachlässigt werden kann.

Die Forderungen einerseits nach einer hohen Lichtempfindlichkeit und anderseits nach einer guten Lichtausbeute bei geringer Anregungsenergie verlangen hinsichtlich des Aufbaus der photoaktiven Schicht unterschiedliche Maßnahmen. Aus diesem Grunde weist die photoaktive Schicht im Bereich der lichtemittierenden Elemente einen gegenüber den Bereichen der lichtempfindlichen Elemente unterschiedlichen Aufbau auf. So können für die lichtempfindlichen Bereiche der photoaktiven Schicht zwei molekulare Komponenten, nämlich eine konjugierte Polymerkomponente als Elektronendonator und eine Fullerenkomponente als Elektronenakzeptor, eingesetzt werden, während für die lichtemittierenden Elemente lediglich ein konjugiertes Polymer Verwendung findet. Durch das Fehlen eines Elektronenakzeptors kann beim Anlegen einer elektrischen Spannung an diese Polymerbereiche Licht emittiert werden.

Die lichtempfindliche Lage kann auf der von den Proben abgekehrten Seite des Probenträgers oder zwischen dem Probenträger und den Proben vorgesehen werden. In beiden Ausführungsmöglichkeiten kann das von den Proben kommende Licht ohne optisches Linsensystem unmittelbar über die photoaktive Schicht erfaßt werden. Die photoaktive Schicht auf der von den Proben abgewandten Seite des Probenträgers erfordert allerdings eine zumindest bereichsweise Lichtdurchlässigkeit des Probenträgers.

Wird die aufgrund einer Reaktion der Proben mit einem Reagenz bedingte spektrale Änderung der Lichtabsorption überwacht, so kann hierfür eine Lichtreflexion an den Proben genützt werden. Gleiches gilt für die Auswertung einer durch Licht angeregten Strahlung, z. B. einer Fluoreszenzstrahlung. In diesen Fällen kann das für die Reflexion benötigte Licht bzw. das zur Anregung der Strahlung der entsprechend markierten Biomoleküle erforderliche Licht von einer lichtemittierenden Lage auf der von den Proben abgewandten Seite der lichtempfndlichen Lage gesendet werden, die zu diesem Zweck lichtdurchlässig auszubilden ist, was im Hinblick auf den Einsatz organischer Halbleiter für die photoaktive Schicht keinerlei Schwierigkeiten bereitet.

Die lichtemittierende Lage kann aus Elektrolumineszenzdioden in Dünnschichttechnik aufgebaut sein. Besonders vorteilhafte Konstruktionsbedingungen ergeben sich allerdings, wenn die lichtemittierende Lage eine photoaktive Schicht auf der Basis organischer Halbleiter zwischen zwei Elektrodenschichten aufweist, von denen die Elektrodenschicht zwischen der photoaktiven Schicht und der lichtempfindlichen Lage zumindest bereichsweise lichtdurchlässig ist. Für die lichtemittierende Lage können somit ähnliche Vorteile hinsichtlich des Aufbaus und der Ansteuerung wie bei der Lage lichtempfindlicher Elemente genützt werden, vor allem dann, wenn die beiden Elektrodenschichten für die photoaktive Schicht der lichtemittierenden Lage einander kreuzende Leiterbahnen aufweisen, die im Kreuzungsbereich lichtemittierende Elemente in der photoaktiven Schicht begrenzen.

Die Elektrodenschichten auf den einander zugekehrten Seiten der beiden photoaktiven Schichten für die lichtempfindliche und die lichtemittierende Lage können durch eine Isolationsschicht voneinander getrennt werden. Es ist aber auch möglich, für die photoaktive Schicht der lichtempfindlichen Lage und die photoaktive Schicht der lichtemittierenden Lage eine gemeinsame Elektrodenschicht zwischen den beiden Lagen vorzusehen, was eine Konstruktionsvereinfachung mit sich bringt.

Die Ausgangssignale der lichtempfindlichen Elemente können in Abhängigkeit von der örtlichen Lage der jeweils angesteuerten lichtemittierenden Elemente in die Auswerteschaltung ausgelesen werden. In diesem Fall wird es möglich, die Proben in Abhängigkeit von der Ansteuerung der lichtemittierenden Elemente einzeln oder gruppenweise auszuwerten, was die zur Verfügung zu stellende Anregungsenergie für die lichtemittierenden Elemente begrenzt, die ja in einer beliebigen Reihenfolge nacheinander angesteuert werden können. Darüber hinaus können die Ausgangssignale der lichtempfindlichen Elemente auch in zeitlicher Abhängigkeit von der Ansteuerung der lichtemittierenden Elemente vorgenommen werden. Durch diese Maßnahme kann sichergestellt werden, daß das emittierte Licht zur Anregung einer Fluoreszenzstrahlung die Messung der Fluoreszenzstrahlung nicht beeinträchtigt.

In der Zeichnung ist der Erfindungsgegenstand beispielsweise dargestellt. Es zeigen
- Fig. 1: eine Vorrichtung zum Auswerten biochemischer Proben in einem vereinfachten Querschnitt,
- Fig. 2: eine der Fig. 1 entsprechende Darstellung einer Konstruktionsvariante,
- Fig. 3: den grundsätzlichen Aufbau einer Lage lichtempfindlicher Elemente in einem Querschnitt,
- Fig. 4: die Lage lichtempfindlicher Elemente gemäß der Fig. 3 in einer zum Teil aufgerissenen Draufsicht,
- Fig. 5: eine weitere Ausführungsform einer Vorrichtung, die neben einer Lage lichtempfindlicher Elemente eine Lage lichtemittierender Elemente aufweist, in einem schematischen Querschnitt, die
- Fig. 6 und 7: der Fig. 5 entsprechende Vorrichtungen in abgewandelten Ausfüh- rungsformen,
- Fig. 8: eine Lage lichtemittierender Elemente in einer zum Teil aufgerissenen Drauf- sicht und
- Fig. 9: eine photoaktive Schicht, die sowohl lichtempfindliche als auch lichtemittie- rende Elemente bildet, in einer zum Teil aufgerissenen Draufsicht.

### Weg zur Ausführung der Erfindung

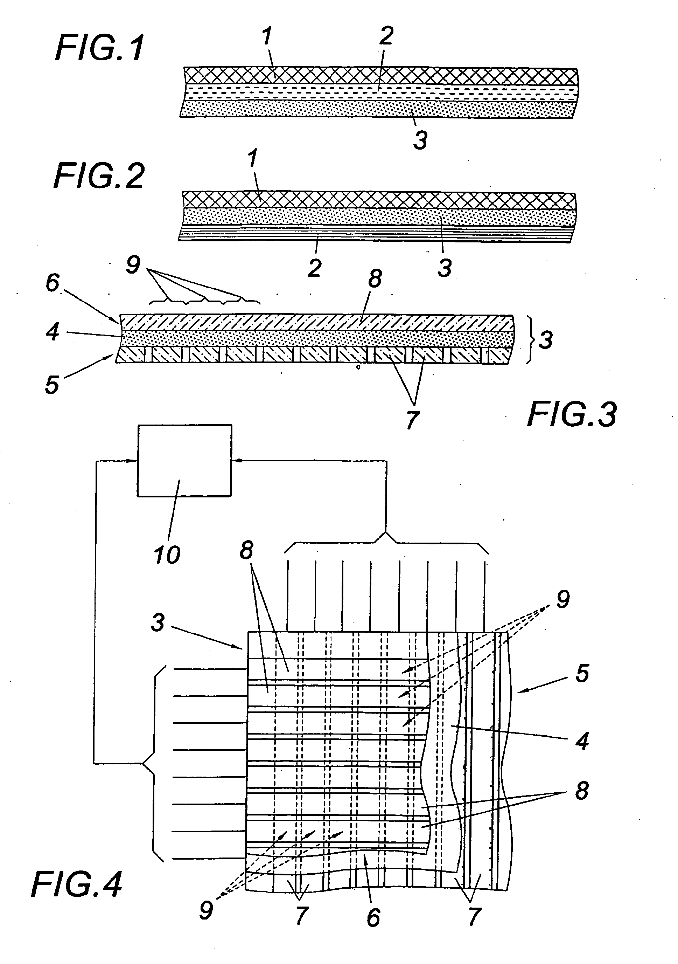

Gemäß der Fig. 1 sind die auszuwertenden biochemischen Proben 1 auf einem lichtdurchlässigen Probenträger 2 aufgebracht, und zwar entweder in Form einer durchgehenden Schicht oder in voneinander getrennten Bereichen. Auf der den Proben 1 abgekehrten Seite des lichtdurchlässigen Probenträgers 2 ist eine lichtempfindliche Lage 3 vorgesehen, mit deren Hilfe die bei einer entsprechenden Reaktion der Proben mit einem Reagenz auftretende spektrale Änderung der Absorption einer Lichtstrahlung durch die Erfassung des Durchlichtes oder eine mit Hilfe von Licht angeregte Fluoreszenzstrahlung entsprechend markierter Biomoleküle bestimmt werden kann. Wie die Fig. 2 erkennen läßt, kann die lichtempfindliche Lage 3 auch zwischen den Proben 1 und dem Probenträger 2 angeordnet werden, so daß die Proben 1 gegebenenfalls unter Zwischenschaltung einer Isolationsschicht auf die lichtempfindliche Lage 3 aufgebracht werden. In diesem Fall braucht der Probenträger 2 nicht lichtdurchlässig ausgebildet zu sein.

Die lichtempfindliche Lage 3 weist nach den Fig. 3 und 4 eine photoaktive Schicht 4 zwischen zwei anliegenden Elektrodenschichten 5, 6 aus einander kreuzenden Leiterbahnen 7, 8 auf. Die photoaktive Schicht 4 ist auf der Basis organischer Halbleiter aufgebaut, deren Ladungsbeweglichkeit parallel zur Schichtfläche vergleichsweise klein ist, so daß sich im Kreuzungsbereich der Leiterbahnen 7, 8 voneinander im wesentlichen getrennte lichtempfindliche Elemente 9 ergeben. Obwohl die photoaktive Schicht 4 unterschiedlich aufgebaut sein kann, ergeben sich hinsichtlich der Ausbildung der lichtempfindlichen Elemente besonders günstige Verhältnisse, wenn die photoaktive Schicht 4 aus zwei molekularen organischen Komponenten zusammengesetzt ist, nämlich aus einer konjugierten Polymerkomponente als Elektronendonator und einer Fullerenkomponente als Elektronenakzeptor. Die lichtempfindlichen Elemente 9 sind über die Leiterbahnen 7, 8 an eine Auswerteschaltung 10 angeschlossen, wie dies in der Fig. 4 blockschaltbildartig angedeutet ist. Die Ausgangssignale der lichtempfindlichen Elemente 9 der Lage 3 können somit in einer beliebigen Reihenfolge in die Auswerteschaltung 10 zur Auswertung der Proben 1 ausgelesen werden. Da die von den Proben 1 empfangene Lichtstrahlung die Elektrodenschicht 6 zwischen den Proben 1 und der photoaktiven Schicht 4 durchdringen muß, ist diese Elektrodenschicht 6 zumindest bereichsweise lichtdurchlässig auszubilden.

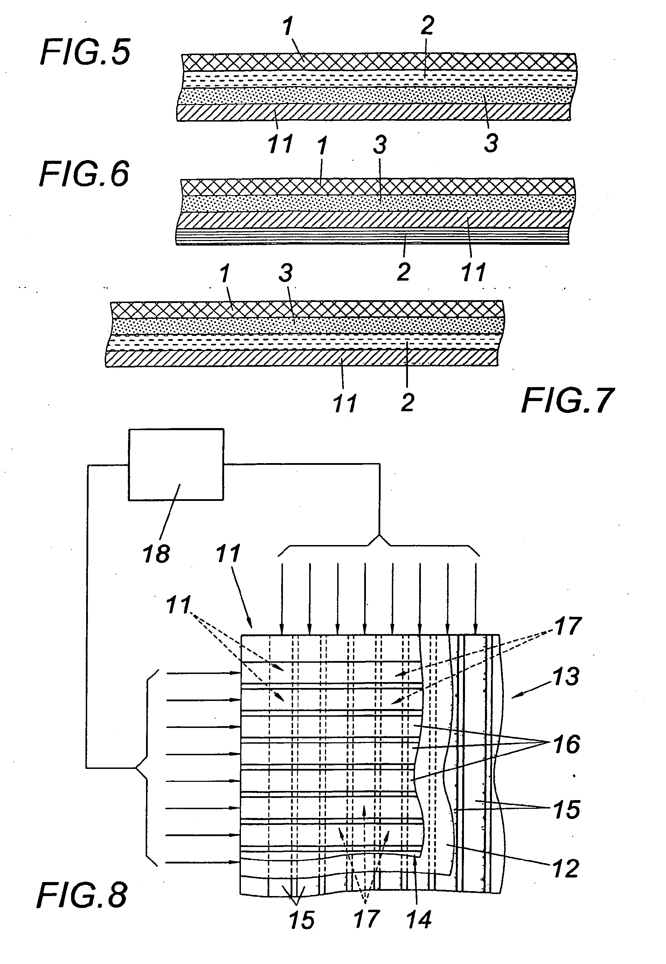

Die Beleuchtung der Proben 1 kann von außen erfolgen, also von der der lichtempfindlichen Lage 3 abgekehrten Seite der Proben 1 her. Günstigere Konstruktions-verhältnisse ergeben sich allerdings, wenn zur Beleuchtung der Proben 1 eine dem Probenträger 2 zugeordnete lichtemittierende Lage 11 vorgesehen wird, wie dies in den Fig. 5, 6 und 7 dargestellt ist. Die Vorrichtung nach der Fig. 5, die von einer Anordnung der lichtempfindlichen Lage 3 gemäß der Fig. 1 ausgeht, bildet die lichtemittierende Lage 11 auf der dem Probenträger 2 abgewandten Seite der lichtempfindlichen Lage 3. Dies bedeutet, daß nicht nur die photoaktive Schicht 4, sondern auch die anliegenden Elektrodenschichten 5 und 6 zumindest bereichsweise lichtdurchlässig ausgebildet werden müssen. Die Vorrichtungen gemäß den Fig. 6 und 7 gehen von einer Anordnung der lichtempfindlichen Lage 3 entsprechend der Fig. 2 aus, wobei nach der Fig. 6 die lichtemittierende Lage 11 zwischen dem Probenträger 2 und der lichtempfindlichen Lage 3 vorgesehen ist. Zum Unterschied dazu wird nach der Fig. 7 die lichtemittierende Lage 11 auf die von der lichtempfindlichen Lage 3 abgekehrte Seite des Probenträgers 2 verlagert, der in diesem Fall zumindest bereichsweise lichtdurchlässig sein muß.

Die lichtemittierende Lage 11 kann vorteilhaft entsprechend der lichtempfindlichen Lage 3 eine photoaktive Schicht 12 auf der Basis organischer Halbleiter zwischen zwei Elektrodenschichten 13 und 14 aufweisen, wie dies in der Fig. 8 angedeutet ist. Diese Elektrodenschichten 13 und 14 können wiederum einander kreuzende Leiterbahnen 15, 16 umfassen, in deren Kreuzungsbereich sich die einzeln ansteuerbaren lichtemittierenden Elemente 17 ergeben. Die einzelnen Leiterbahnen 15 und 16 können über eine Steuereinrichtung 18 mit einer elektrischen Spannung beaufschlagt werden, um die jeweils angesteuerten Elemente 17 zur Abgabe einer Lichtstrahlung anzuregen, die die photoaktive Schicht 4 der Lage 3 lichtempfindlicher Elemente und gegebenenfalls den Probenträger 2 durchdringt, damit die Proben 1 bei einer entsprechenden Markierung zur Abgabe einer Strahlung angeregt werden, die wiederum von den lichtempfindlichen Elementen 9 der Lage 3 erfaßt und in der Auswerteschaltung 10 ausgewertet wird. Zum Auslesen der Ausgangssignale der lichtempfindlichen Elemente 9 kann sowohl eine örtliche Abhängigkeit als auch eine zeitliche Abhängigkeit von der Ansteuerung der lichtemittierenden Elemente 17 genützt werden, um einer Messung aus dem Wege zu gehen, die neben dem von den Proben 1 empfangenen Licht zusätzlich die durch das emittierte Licht der Lage 11 bedingte Grundbelastung der lichtempfindlichen Elemente berücksichtigt, obwohl eine solche Messung ebenfalls möglich ist.

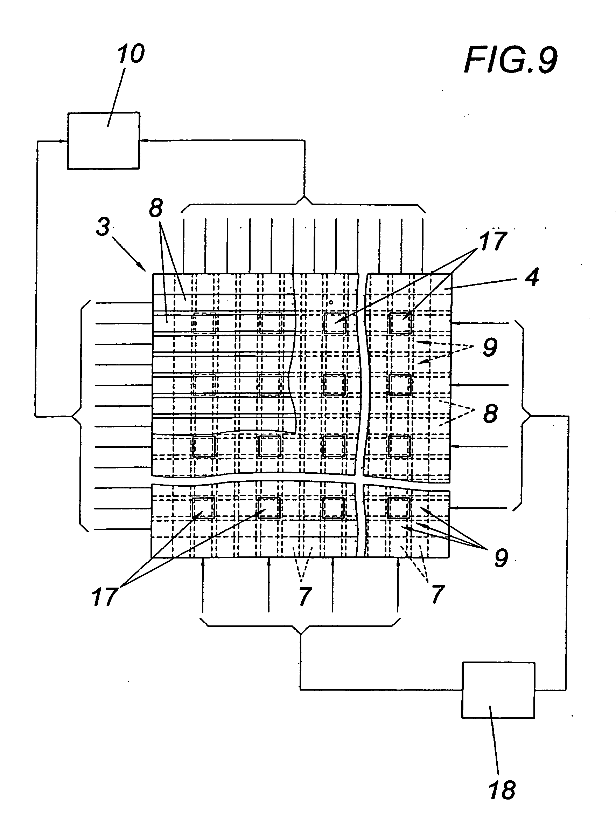

Aufgrund des Aufbaus einer photoaktiven Schicht auf der Basis organischer Halbleiter können die sich im Kreuzungsbereich von Leiterbahnen ergebenden Bereiche einer solchen photoaktiven Schicht je nach der Beaufschlagung sowohl als lichtemittierende als auch lichtempfindliche Elemente dienen. Es braucht daher keine gesonderte Lage 11 lichtemittierender Elemente vorgesehen zu werden, wenn die photoaktive Schicht 4 lichtemittierende Elemente 17 in vorgegebenen Kreuzungsbereichen der Leiterbahnen 7 und 8 bildet. In der Fig. 9 ist eine solche Lage 3 mit zusätzlichen lichtemittierenden Elementen 17 angedeutet. Zu diesem Zweck kann die photoaktive Schicht 4 für die lichtempfindlichen Elemente 9 und die lichtemittierenden Elemente 17 einen unterschiedlichen Aufbau aufweisen. Im örtlichen Bereich der lichtemittierenden Elemente 17 besteht die photoaktive Schicht 4 vorzugsweise nur aus einem konjugierten Polymer, während sich die photoaktive Schicht im übrigen Bereich aus zwei molekularen organischen Komponenten zusammensetzt, nämlich einer konjugierten Polymerkomponente als Elektronendonator und einer Fullerenkomponente als Elektronenakzeptor. In der Fig. 9 sind diese unterschiedlichen Bereiche für die Elemente 9 und 17 angedeutet, wobei die lichtempfindlichen Elemente 9 über die Leiterbahnen 7, 8 an die Auswerteschaltung 10 angeschlossen sind, während die lichtemittierenden Elemente 17 über eine Steuereinrichtung 18 angesteuert werden, die mit den einander im Bereich der lichtemittierenden Elemente 17 kreuzenden Leiterbahnen 7, 8 verbunden ist.

## Patentansprüche

1. Vorrichtung zum Auswerten biochemischer Proben mit einem Probenträger (2), mit einer Bilderfassungseinrichtung, die eine an eine Auswerteschaltung (10) angeschlossene lichtempfindliche Lage (3) aufweist, und mit einer Beleuchtungseinrichtung für die Proben (1), wobei die auf dem Probenträger (2) vorgesehene lichtempfindliche Lage (3) der Bilderfassungseinrichtung eine photoaktive Schicht (4) auf der Basis organischer Halbleiter zwischen zwei Elektrodenschichten (5, 6) umfaßt, von denen die Elektrodenschicht (6) zwischen der photoaktiven Schicht (4) und den Proben (1) zumindest bereichsweise lichtdurchlässig ausgebildet ist, **dadurch gekennzeichnet, daß** die beiden Elektrodenschichten (5, 6) für die photoaktive Schicht (4) aus einander kreuzenden Leiterbahnen (7, 8) aufgebaut sind, die im Kreuzungsbereich lichtempfindliche Elemente (9) in der photoaktiven Schicht (4) begrenzen, daß die photoaktive Schicht (4) neben den lichtempfindlichen Elementen (9) lichtemittierende Elemente (17) in ausgewählten Kreuzungsbereichen der Leiterbahnen (7, 8) der beiden Elektrodenschichten (5, 6) bildet und daß die photoaktive Schicht (4) im Bereich der lichtemittierenden Elemente (17) einen gegenüber den Bereichen der lichtempfindlichen Elemente (9) unterschiedlichen Aufbau aufweist.

2. Vorrichtung nach Anspruch 1, **dadurch gekennzeichnet, daß** die lichtempfindliche Lage (3) auf der von den Proben (1) abgekehrten Seite des zumindest bereichsweise lichtdurchlässigen Probenträgers (2) vorgesehen ist.

3. Vorrichtung nach Anspruch 1, **dadurch gekennzeichnet, daß** die lichtempfindliche Lage (3) zwischen dem Probenträger (2) und den Proben (1) vorgesehen ist.

4. Vorrichtung nach einem der Ansprüche 1 bis 3, **dadurch gekennzeichnet, daß** die Beleuchtungseinrichtung eine lichtemittierende Lage (11) auf der von den Proben (1) abgewandten Seite der zumindest bereichsweise lichtdurchlässig ausgebildeten, lichtempfindlichen Lage (3) aufweist.

5. Vorrichtung nach Anspruch 4, **dadurch gekennzeichnet, daß** die lichtemittierende Lage (11) eine photoaktive Schicht (12) auf der Basis eines organischen Halbleiters zwischen zwei Elektrodenschichten (13, 14) aufweist, von denen die Elektrodenschicht (14) zwischen der photoaktiven Schicht (12) und der lichtempfindlichen Lage (3) zumindest bereichsweise lichtdurchlässig ist.

6. Vorrichtung nach Anspruch 5, **dadurch gekennzeichnet, daß** die beiden Elektrodenschichten (13, 14) für die photoaktive Schicht (12) der lichtemittierenden Lage (11) einander kreuzende Leiterbahnen (15, 16) aufweisen, die im Kreuzungsbereich lichtemittierende Elemente (17) in der photoaktiven Schicht (12) begrenzen.

7. Vorrichtung nach Anspruch 5 oder 6, **dadurch gekennzeichnet, daß** die photoaktive Schicht (4) der lichtempfindlichen Lage (3) und die photoaktive Schicht (12) der lichtemittierenden Lage (11) zwischen sich eine gemeinsame Elektrodenschicht aufweisen.

8. Vorrichtung nach einem der Ansprüche 4 bis 7, **dadurch gekennzeichnet, daß** die Ausgangssignale der lichtempfindlichen Elemente (9) in Abhängigkeit von der örtlichen Lage der jeweils angesteuerten lichtemittierenden Elemente (17) in die Auswerteschaltung (10) auslesbar sind.

9. Vorrichtung nach einem der Ansprüche 4 bis 8, **dadurch gekennzeichnet, daß** die Ausgangssignale der lichtempfindlichen Elemente (9) in zeitlicher Abhängigkeit von der Ansteuerung der lichtemittierenden Elemente (17) in die Auswerteschaltung (10) auslesbar sind.

## Claims

1. Device for evaluating biochemical samples, having a sample carrier (2), with an image recording device which comprises a light-sensitive layer (3) which is connected to an evaluation circuit (10), and with an illumination device for the samples (1), wherein the light-sensitive layer (3), which is provided on the sample carrier (2), of the image recording device comprises a photoactive layer (4) based on organic semiconductors between two electrode layers (5, 6), of which the electrode layer (6) between the photoactive layer (4) and the samples (1) is formed in such a manner as to be translucent at least in certain regions, **characterised in that** the two electrode layers (5, 6) for the photoactive layer (4) are constructed from mutually intersecting strip conductors (7, 8) which in the region of intersection define light-sensitive elements (9) in the photo active layer (4), **in that** the photoactive layer (4) adjacent to the light-sensitive elements (9) forms light-emitting elements (17) in selected regions of intersection of the strip conductors (7, 8) of the two electrode layers (5, 6), and **in that** in the region of the light-emitting elements (17) the photoactive layer (4) comprises a structure which is different from the regions of the light-sensitive elements (9).

2. Device as claimed in claim 1, **characterised in that** the light-sensitive layer (3) is provided on the side, remote from the samples (1), of the sample carrier (2) which is translucent at least in certain regions.

3. Device as claimed in claim 1, **characterised in that** the light-sensitive layer (3) is provided between the sample carrier (2) and the samples (1).

4. Device as claimed in any one of claims 1 to 3, **characterised in that** the illumination device comprises a light-emiuing layer (11) on the side remote from the samples (1). of the light-sensitive layer (3) which is formed so as to be translucent at least in certain regions.

5. Device as claimed in claim 4, **characterised in that** the light-emitting layer (11) comprises a photoactive layer (12) based on an organic semiconductor between two electrode layers (13, 14), of which the electrode layer (14) between the photoactive layer (12) and the light-sensitive layer (3) is translucent at least in certain regions.

6. Device as claimed in claim 5, **characterised in that** the two electrode layers (13, 14) for the photoactive layer (12) of the light-emitting layer (11) comprise mutually intersecting strip conductors (15, 16) which in the region of intersection define light-emitting elements (17) in the photoactive layer (12).

7. Device as claimed in claim 5 or 6, **characterised in that** the photoactive layer (4) of the light-sensitive layer (3) and the photoactive layer (12) of the light-emitting layer (11) comprise a common electrode layer therebetween.

8. Device as claimed in any one of claims 4 to 7, **characterised in that** the output signals of the light-sensitive elements (9) can be read out into the evaluation circuit (10) as a function of the local position of the respectively controlled light-emitting elements (17).

9. Device as claimed in any one of claims 4 to 8, **characterised in that** the output signals of the light-sensitive elements (9) can be read out into the evaluation circuit (10) as a function with respect to time of the control of the light-emitting elements (17).

## Revendications

1. Dispositif d'évaluation d'échantillons biochimiques avec un porte-échantillon (2), avec un dispositif de détection d'images présentant une strate (3) photosensible raccordée à un circuit d'évaluation (10), et avec un dispositif d'éclairage pour les échantillons (1), la strate (3) photosensible, prévue sur le porte-échantillon (2), du dispositif de détection d'images comprenant une couche (4) photoaktive à base de semi-conducteurs organiques, disposée entre deux couches d'électrodes (5, 6), dont la couche d'électrode (6) est réalisée da façon transparente, au moins par zones, entre la couche photoactive (4) et l'échantillon (1),
**caractérisé en ce que** les deux couches d'électrode (5, 6) pour la couche (4) photoactive sont constituées de pistes conductrices (7, 8) se croisant les unes les autres, délimitant, dans la zone de croisement, des éléments (9) photosensibles dans la couche (4) photoactive, **en ce que** la couche (4) photoactive forme, outre les éléments (9) photosensibles, des éléments (17) photoémetteurs dans des zones de croisement sélectionnées des pistes conductrices (7, 8) des deux couches d'électrodes (5, 6), et **en ce que** la couche (4) photoactive présente, dans la zone des éléments (17) photoémetteurs, une structure différente de celle des zones des éléments (9) photosensibles.

2. Dispositif selon la revendication 1, **caractérisé en ce que** la strate (3) photosensible est prévue sur la face, opposée aux échantillons (1), du porte-échantillon (2) transparent, au moins par zones.

3. Dispositif selon la revendication 1, **caractérisé en ce que** la strate (3) photosensible est prévue entre le porte-échantillon (2) et l'échantillon (1).

4. Dispositif selon l'une des revendications 1 à 3, **caractérisé en ce que** le dispositif d'éclairage présente une strate (11) photoémettrice sur la face, opposée aux échantillons (1), de la strate (3) photosensible transparente, au moins par zones.

5. Dispositif selon la revendication 4, **caractérisé en ce que** la strate (11) photoémettrice présente une couche (12) photoactive, à base d'un semi-conducteur organique, disposée entre deux couches d'électrode (13, 14), dont la couche d'électrode (14), disposée entre la couche (12) photoactive et la strate (3) photosensible, est transparente, au moins par zones.

6. Dispositif selon la revendication 5, **caractérisé en ce que** les deux couches d'électrode (13, 14) pour la couche (12) photoactive de la strate (11) photoémettrice présentent des pistes conductrices (15, 16) se croisant les unes les autres, délimitant, dans la zone de croisement, des éléments (17) photoémetteurs dans la couche (12) photoactive.

7. Dispositif selon la revendication 5 ou 6, **caractérisé en ce que** la couche (4) photoactive de la strate (3) photosensible et la couche (12) photoactive de la strate (11) photoémettrice présentent entre elles une couche d'électrode commune.

8. Dispositif selon l'une des revendications 4 à 7, **caractérisé en ce que** les signaux de sortie des éléments (9) photosensibles sont susceptibles d'être lus en fonction de la position locale des éléments (17) photoémetteurs commandés chacun dans le circuit d'évaluation (10).

9. Dispositif selon l'une des revendications 4 à 8, **caractérisé en ce que** les signaux de sortie des éléments (9) photosensibles sont susceptibles d'être lus, en fonction du temps, par la commande des éléments (17) photoémetteurs dans le circuit d'évaluation (10).
